(19) Europäisches Patentamt
European Patent Office
Office européen des brevets

(11) Numéro de publication: **0 022 013**
**B1**

(12) **FASCICULE DE BREVET EUROPEEN**

(45) Date de publication du fascicule du brevet: **25.01.84**

(51) Int. Cl.³: **C 30 B 7/00**, C 30 B 29/12, C 01 G 13/04

(21) Numéro de dépôt: **80400932.2**

(22) Date de dépôt: **23.06.80**

(54) **Monocristaux d'iodure mercurique alpha et leur procédé de fabrication.**

(30) Priorité: **26.06.79 FR 7916418**

(43) Date de publication de la demande: **07.01.81 Bulletin 81/1**

(45) Mention de la délivrance du brevet: **25.01.84 Bulletin 84/4**

(84) Etats contractants désignés: **DE GB NL**

(56) Documents cités:
**FR - A - 2 338 742**
**US - A - 3 969 182**

**JOURNAL OF CRYSTAL GROWTH, vol. 48, no. 1, janvier 1980 Amsterdam NL I.F. NICOLAU et al.: *"Solution growth of sparingly soluble single crystals from soluble complexes, III. Growth of alpha-HgI2 single crystals from dimethyl-sulfoxide complexes"*, pages 61-73**

(73) Titulaire: **COMMISSARIAT A L'ENERGIE ATOMIQUE Etablissement de Caractère Scientifique Technique et Industriel, B.P. 510, F-75752 Paris Cedex 15 (FR)**

(72) Inventeur: **Nicolau, Ion Florin, 209, Avenue de Grenoble, F-38170 Seyssins (FR)**

(74) Mandataire: **Mongrédien, André et al, c/o BREVATOME 25, rue de Ponthieu, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).



ACTORUM AG

# Monocristaux d'iodure mercurique alpha et leur procédé de fabrication

La présente invention a pour objet un procédé de fabrication de monocristaux d'iodure mercurique alpha ($\alpha$-$HgI_2$).

Jusqu'à présent, on a essayé diverses méthodes pour tenter d'obtenir des monocristaux d'iodure mercurique alpha de pureté et de qualité cristalline satisfaisante, en particulier des méthodes par croissance en solution, ou par croissance en phase vapeur. A partir de la phase vapeur, un procédé connu consiste à faire croître un monocristal d'$\alpha$-$HgI_2$ à l'extrémité d'un tube en quartz fermé, par transport de masse sous vide à partir d'une source polycristalline annulaire d'$\alpha$-$HgI_2$ placée dans le tube à l'autre extrémité, la température du cristal étant maintenue constante, par exemple à 100 °C, cependant que la température de la source oscille entre 102 °C et 98 °C.

Ce procédé permet d'obtenir des monocristaux d'$\alpha$-$HgI_2$ jusqu'à 30 g en 3 à 12 jours. A partir des cristaux obtenus selon ce procédé, on a fabriqué des détecteurs X et Y performants, présentant un produit $\mu_e\tau_e$ de l'ordre de $10^{-4}cm^2/V$ et un produit $\mu_h\tau_h$ de l'ordre de $10^{-6}$ $cm^2/V$. Ici, $\mu$ désigne la mobilité des porteurs de charge, $\tau$ leur durée de vie, pour les électrons avec l'indice e et pour les trous avec l'indice h. Mais, ce procédé présente plusieurs inconvénients.

Le principal inconvénient est lié à son principe de fonctionnement qui fait se succéder des périodes de croissance séparées par des périodes de décapage. Il en résulte que le cristal est marqué par des anneaux de croissance où se trouvent concentrés des défauts de croissance et des impuretés.

Un autre inconvénient majeur concerne la stœchiométrie du cristal, qui ne peut pas être contrôlée pendant la croissance. Les cristaux qui poussent à partir des polycristaux de haute pureté poussent difficilement; ils présentent un faciès prismatique-pinacoïdal et sont riches en mercure. Le cristal se développe par l'avancement des faces (110) du prisme, faces qui captent facilement des impuretés (le mercure en excès compte comme une impureté) et les défauts de croissance se propagent dans toute la masse du cristal. L'ajout d'iode pendant la croissance bloque les faces qui ne peuvent plus faire croître le monocristal.

De plus, le cristal pousse à partir d'un germe obtenu par nucléation spontanée, c'est-à-dire qu'en début de croissance on sélectionne parmi plusieurs germes celui que l'on fait pousser. Mais par nucléation spontanée, on ne peut pas contrôler l'orientation du cristal par rapport au tube et puis comme le germe n'est jamais parfait, il engendre toujours des défauts qui se propagent dans la masse du cristal.

En fin de croissance, le cristal obtenu est refroidi à la température ambiante, ce qui lui fait subir des déformations supplémentaires.

Ainsi, ce procédé de fabrication ne permet pas d'obtenir de façon systématique des monocristaux satisfaisants. Il n'est pas reproductible. Les cristaux ne sont jamais entièrement utilisables. Il faut découper après la croissance les parties bonnes, qui représentent seulement 3/4 du volume du cristal. La densité des dislocations est de l'ordre de $10^4$–$10^7$ $cm^{-2}$.

On connaît aussi un procédé de purification d'$\alpha$-$HgI_2$ par fusion de zones et par sublimations successives. Ce procédé permet d'obtenir un $\alpha$-$HgI_2$ de haute pureté, mais il est extrêmement laborieux dans sa mise en œuvre et d'un très faible rendement. Ainsi, pour arriver à la haute pureté, il faut 30–100 fusions de zones et 6–30 sublimations successives. On ne connaît guère qu'un procédé qui donne des résultats satisfaisants. Ce procédé fait l'objet de la demande de brevet 7 602 031 déposée le 26 janvier 1976 au nom du Commissariat à l'Energie Atomique (FR-A-2 338 742).

Ce procédé connu de fabrication de monocristaux d'iodure mercurique alpha consiste à mettre en solution dans un solvant organique de l'iodure mercurique alpha et au moins un dialcoyl-sulfoxyde, le rapport molaire du dialcoyl-sulfoxyde par rapport au solvant étant compris entre 0,01 et 0,1 mole de dialcoyl-sulfoxyde par mole de solvant et le rapport molaire de l'iodure mercurique alpha par rapport au dialcoyl-sulfoxyde étant compris entre 0,5 et 0,6 mole d'iodure mercurique alpha par mole de dialcoyl-sulfoxyde, et à faire croître à partir de ladite solution des monocristaux d'iodure mercurique alpha.

Les dialcoyl-sulfoxydes utilisés sont choisis dans le groupe comprenant le diméthyl-sulfoxyde, le méthyl-éthyl sulfoxyde et le diéthyl-sulfoxyde avec une préférence pour le diméthyl-sulfoxyde (DMSO).

Les solvants organiques utilisés sont des solvants aliphatiques saturés moyennement polaires et stables en présence d'iodure mercurique, notamment des esters provenant de l'estérification de l'acide acétique par des alcools aliphatiques saturés, tels que l'acétate de méthyle, l'acétate d'éthyle, l'acétate de propyle et l'acétate de butyle, les monocétones aliphatiques saturées telles que l'acétone, la méthyl-éthyl-cétone, la diéthylcétone et la dipropylcétone, et les nitrodérivés aliphatiques saturés tels que le nitroéthane et le nitropropane. On fait croître les monocristaux d'iodure mercurique alpha par abaissement de la température de la solution, par évaporation du solvant ou par circulation de la solution entre un récipient contenant des polycristaux d'iodure mercurique et un récipient contenant des germes monocristallins d'iodure mercurique alpha. L'iodure mercurique alpha matière première est synthétisé à partir d'iode 5N et de mercure 7N en solution dans un mélange de diméthylsulfoxyde et d'acétate d'éthyle et purifié davantage par recristallisations successives en utilisant des solutions de même composition.

Bien que ce procédé soit déjà fort satisfaisant, il présente cependant trois inconvénients. En premier lieu, les monocristaux d'iodure mercurique alpha obtenus présentent un écart notable par rapport à la composition stœchiométrique exacte, par enrichissement en mercure. Le second inconvénient est que l'on obtient des monocristaux d'iodure mercurique alpha de faciès prismatique-pinacoïdal et de ce fait, les cristaux obtenus présentent certaines imperfections dues à des dislocations coin et à des fautes d'empilements dans les secteurs de croissance qui correspondent à l'avancement des faces (110). Le troisième inconvénient est lié au fait que les solutions d'iodure mercurique alpha deviennent impures pendant la synthèse, la purification et la croissance, par dissolution d'impuretés provenant du verre borosilicate utilisé pour tous les récipients recevant les solutions.

Toutes ces imperfections, liées à l'écart par rapport à la stœchiométrie, aux dislocations et aux impuretés, sont néfastes pour certaines applications des monocristaux d'iodure mercurique alpha, notamment pour leur utilisation dans des détecteurs et des spectromètres de radiations X et gamma.

Le procédé, objet de l'invention, pallie les inconvénients rappelés ci-dessus, notamment en ce qu'il permet d'obtenir des monocristaux d'iodure mercurique alpha présentant un faciès octaédrique-pinacoïdal et d'éliminer ainsi les dislocations coin et/ou vis et les fautes d'empilement provenant du germe par l'avancement des faces d'octaèdre (011).

On connaît un autre procédé de fabrication de monocristaux d'iodure mercurique alpha qui utilise le DMSO comme solvant, ou à proprement parler comme agent complexant. D'après ce procédé, on dissout de l'$HgI_2$ dans du DMSO à la saturation entre 20 et 80 °C, par exemple suivant un rapport molaire ($HgI_2$)/(DMSO) d'environ 0,5, on filtre la solution sur un filtre en verre fritté, puis on laisse le récipient en verre, contenant la solution, ouvert en contact avec de l'air humide à 15–50% d'humidité pour cristalliser pendant un temps de 0,5 à 24 heures. L'humidité diminue la solubilité de $HgI_2$, qui cristallise par germination spontanée sur le fond du récipient. On obtient des cristaux de $10^{-2}$ jusqu'à 7,5 cm³. On peut aussi diluer le DMSO avec du xylène ou du toluène jusqu'à l'obtention d'une solution saturée en $HgI_2$ avec un rapport molaire ($HgI_2$)/(DMSO) = 0,33, puis cristalliser $\alpha$-$HgI_2$ par absorption de l'humidité comme plus haut. Ce procédé est inadapté aux exigences pratiques. Les cristaux développent des faces du prisme (110) et sont très distordus. Par leur qualité cristalline et leurs impuretés, les monocristaux obtenus sont inutilisables pour la détection nucléaire. Ils se caractérisent par un produit $\mu_e\tau_e = 4 \times 10^{-8}$ cm²/V et $\mu_h\tau_h$ non mesurable ($\mu$ étant la mobilité des porteurs de charge et $\tau$ étant leur durée de vie comme plus haut). En fait, il n'est pas possible d'obtenir des monocristaux de $\alpha$-$HgI_2$ sans inclusions de DMSO et d'eau à partir des solutions saturées en $HgI_2$ dans le DMSO pur et les inclusions portent un grave préjudice à la qualité des cristaux puisqu'elles rendent le produit des électrons ($\mu_e\tau_e$) faible et celui des trous ($\mu_h\tau_h$) extrêmement faible.

La dilution du DMSO par le xylène ou par le toluène rend les monocristaux de $HgI_2$ d'autant plus inutilisables que l'$HgI_2$ réagit avec ces solvants aromatiques, en produisant des composés organo-métalliques qui s'ajoutent aux impuretés que la solution absorbe du verre du container, et surtout du verre fritté au moment de la filtration.

Pour toutes ces raisons, les cristaux obtenus par ce procédé souffrent de ne pas être stœchiométriques, le mercure se trouvant en excès, et ils contiennent un taux de dislocations vis et coin très élevé, de l'ordre de $10^4$–$10^5$ cm$^{-2}$.

Contrairement à tous ces procédés antérieurs, l'invention permet, par un procédé particulièrement simple et facile à mettre en œuvre, d'obtenir avec un bon rendement, des monocristaux d'iodure mercurique alpha améliorés dans leur pureté, leur structure et leurs propriétés en tant qu'éléments de détecteurs de rayonnements. Ceci est obtenu conformément à l'invention en adoptant, dans un procédé par croissance en solution, différentes mesures qui consistent essentiellement à favoriser la croissance sous forme d'un monocristal à faciès octaédrique-pinacoïdal.

L'invention a pour objet un procédé de fabrication de monocristaux d'iodure mercurique alpha à faciès octaédrique-pinacoïdal par croissance en solution selon lequel on utilise une solution d'iodure mercurique alpha dans un sulfoxyde organique, et ce procédé se caractérise en ce que l'on provoque la croissance sur un germe reposant par sa face (100) sur le fond d'une cavité prismatique de section rectangulaire ménagée dans un porte-germe selon la direction [001] du germe, ladite cavité étant en forme de queue d'aronde, avec des faces d'extrémités inclinées pour se rapprocher au-dessus du germe.

On peut utiliser avantageusement comme solution de départ une solution d'iodure mercurique alpha dans un mélange de diméthyl-sulfoxyde et de méthanol exempt d'eau dans lequel la fraction molaire du diméthylsulfoxyde

$$\frac{(DMSO)}{(DMSO) + (MeOH)}$$

est comprise entre 0,6 et 0,9, la solution étant saturée à 25 °C avec un rapport molaire en iodure mercurique

$$\alpha\frac{(HgI_2)}{(DMSO) + (MeOH)}$$

compris entre 0,2 et 0,4. On préfère une solution contenant un excès d'iode, avec un rapport molaire ($I_2$)/($HgI_2$) compris entre $10^{-4}$ et $10^{-2}$. A partir d'une telle solution, la croissance des monocristaux peut avantageusement s'opérer à une température comprise entre 25 et 40 °C, dans des récipients étanches à l'abri de l'humidité. Eventuellement, le diméthylsulfoxyde peut être remplacé par

un autre sulfoxyde organique, tel que le méthyléthylsulfoxyde, le diéthylsulfoxyde, le tétraméthylène sulfoxyde. Dans les cristaux obtenus, le faciès octaédrique-pinacoïdal résulte d'une part du ralentissement de la vitesse de croissance des faces (011) d'octaèdre par une plus forte adsorption des complexes $HgI_2(DMSO)_2$ sur ces faces suite à l'augmentation de la teneur en DMSO du bain de croissance par rapport aux bains de croissance antérieurement utilisés, et, d'autre part, de la vitesse normale de croissance des faces (110) du prisme qui n'est plus ralentie ni par un excès d'iodure mercureux ni par un taux d'impuretés élevé.

La cavité dans laquelle est disposé le germe est ménagée dans un porte-germe qui est avantageusement réalisé en quartz ou en matière plastique du type des polyoléfines, ou polyoléfines fluorés, parmi lesquesl en particulier le polyéthylène, le polypropylène et le polytétrafluoréthylène. Le porte-germe est en général une plaque avec une cavité prismatique en queue d'aronde au fond de laquelle vient reposer par une face (100) un germe monocristallin taillé en forme prismatique d'axe selon la direction [001]. Plus précisément, il est souhaitable d'utiliser un germe prismatique droit à section triangulaire isocèle, limité latéralement par une face (100) et deux faces (110) symétriques et terminé aux extrémités par deux faces (001). La cavité du porte-germe correspondant est avantageusement de forme prismatique à section rectangulaire et terminée par des faces planes qui, aux extrémités du germe, sont inclinées pour se rapprocher au-dessus de lui vers la face ouverte de la cavité par laquelle le germe est mis en place.

Dans la croissance d'un monocristal à faciès octaédrique, qui peut être déjà fortement favorisée par le milieu particulier de croissance choisi, le porte-germe ainsi conçu a pour effet d'empêcher mécaniquement la propagation des dislocations issues du germe, lesquelles se trouvent en outre réfractées entre les faces initiales instables (110) du germe et les fàces stables d'octaèdre (011) en formation.

Finalement, toutes les dislocations sont, soit arrêtées sur les parois intérieures de la cavité, soit éliminées sur les faces du pinacoïde permettant ainsi l'obtention des monocristaux de haute perfection cristalline. Le taux des dislocations vis et/ou coin émergeant sur les faces du pinacoïde ne dépasse pas $10\ cm^{-1}$ en général.

Pourtant, dans les conditions de croissance mentionnées ci-dessus, pour obtenir le faciès octaédrique-pinacoïdal en éliminant totalement les faces du prisme (110), il est utile de disposer d'une solution de haute pureté. D'où l'intérêt de la purification par électrolyse que l'on peut faire subir, selon l'invention, à la solution d'iodure mercurique répondant aux proportions molaires indiquées plus haut, de manière à obtenir une conductivité de moins de $100\ Scm^{-1}$ à 20 °C.

La haute pureté ainsi obtenue résulte de ce que l'iodure mercurique dans les sulfoxydes organiques, tels que le diméthylsulfoxyde et ses homologues est sous forme de complexe non ionisé du type $HgI_2(DMSO)_2$, alors que la plupart des impuretés se trouvant dans l'iodure mercurique, dans l'iode ou dans le mercure lorsqu'il s'agit de produits dits de haute pureté du commerce, sont des iodures qui s'ionisent facilement en solution en se complexant avec l'iodure mercurique et le sulfoxyde.

On décrira maintenant, en se référant aux figs 1 à 3, un mode de mise en œuvre particulier de l'invention, nullement limitatif. Dans l'exemple considéré, des monocristaux d'iodure mercurique alpha sont produits par croissance en solution dans un milieu de diméthylsulfoxyde et méthanol, à partir d'une solution qui est au préalable purifiée par électrolyse. Dans les figures:

– la fig. 1 représente schématiquement un appareillage utilisé pour la purification par électrolyse,

– la fig. 2 représente schématiquement l'appareillage de croissance en solution,

– la fig. 3 illustre la taille du germe et sa disposition dans un porte-germe.

Le principe de la purification du bain de croissance par électrolyse consiste à mettre la solution d'iodure mercurique dans un sulfoxyde à la température ambiante, dans un appareillage en quartz pour semi-conducteurs formant un espace anodique et un espace cathodique, communiquant entre eux, mais séparés par une membrane de quartz frittée et contenant chacun une électrode de graphite spectral pur, et l'on applique une tension de l'ordre de 100 à 300V, en vidant successivement l'espace cathodique de la boue d'iodures mercureux et de la solution concentrée en impuretés, jusqu'à l'obtention d'une solution de haute pureté qui reste dans l'espace anodique plus grand que l'espace cathodique.

Dans l'exemple, on prépare 10 litres de solution saturée à 25 °C d'iodure mercurique alpha du commerce, dans un mélange DMSO-méthanol de fraction molaire

$$\frac{(DMSO)}{(DMSO) + (MeOH)}$$

$= 0{,}8$ (de densité $d^4_{20} = 2{,}425$) en dissolvant 17,090 g d'iodure mercurique alpha dans 5,900 ml DMSO dilué avec 840 ml MeOH dans un ballon en quartz pour semi-conducteurs. Le méthanol est un produit rectifié dans une colonne de conductivité $0{,}16\ \mu S\ cm^{-1}$, le DMSO est un produit du commerce desséché utilisé sans purification supplémentaire, de conductivité $0{,}30\ \mu S\ cm^{-1}$. Ce ballon 1, conformément à la fig. 1, constitue l'espace anodique de l'électrolyseur; il est muni d'un agitateur en quartz 4 et d'une anode en graphite spectral pur 5.

L'espace cathodique est constitué d'un tube de quartz 2, de 100 ml de volume, contenant la cathode 6 en graphite spectral pur. Les deux espaces sont soudés et communiquent entre eux par l'intermédiaire d'une plaque de quartz frittée 3 formant membrane.

La solution ainsi préparée présente une conductivité qui dépend de la pureté de l'iodure mercurique employé; elle peut se trouver dans la gamme de 100 à 400 µ $Scm^{-1}$. En fonction de la conductivité de la solution on applique une tension sur les électrodes qui peut se situer entre 50 et 300V. On limite la puissance qui se dissipe à l'intérieur de la solution, ou on refroidit la solution de sorte qu'elle ne s'échauffe pas à plus de 25 °C. Les courants acceptables sont de l'ordre de 20–100 mA.

Le courant électrique est porté par les anions d'iodomercurate $(HgI_3)^-$, par les cations d'impuretés, et dans une certaine mesure par des cations $(HgI)^+$. Tous ces ions proviennent, soit de la complexation des iodures d'impuretés par l'iodure mercurique selon une réaction générale du type de la suivante pour l'iodure de sodium par exemple:

$$NaI + HgI_2 \rightarrow Na^+ + (HgI_3)^-$$

soit d'une certaine autocomplexation de l'iodure mercurique même selon la réaction:

$$2HgI_2 \rightleftarrows (Hg^+ + (HgI_3)^-$$

A l'anode, les anions d'iodomercurate se déchargent et délivrent de l'iode. Pour éviter la concentration de l'iode, on peut mettre au fond du ballon un excès de mercure de haute pureté 7N(8), qui réagit avec l'iode en reformant l'iodure mercurique. Dans ce cas, pour éviter la sursaturation, on dilue la solution de temps en temps.

A la cathode, les cations d'impuretés se concentrent dans l'espace cathodique: par exemple $Na^+$, $K^+$, $Fe^{3+}$, $Ni^{2+}$, $Cu^{2+}$, $Cu^+$, $Cr^{3+}$, $Ca^{2+}$, $Ag^+$, etc. Les cations $(HgI)^+$ se déchargent en déposant une boue d'iodure mercureux insoluble (7). Certains cations d'impureté se déposent en même temps que la boue d'iodure mercureux ou s'adsorbent dans cette boue. La conductivité de l'espace cathodique augmente d'un ordre ou même de deux ordres de grandeur par la concentration des impuretés ionisées. On vidange l'espace sous tension et on continue l'électrolyse. La conductivité de l'espace anodique diminue progressivement par suite de la purification et reste stationnaire à 110 $\mu Scm^{-1}$ à 20 °C, valeur approximative puisqu'elle est tributaire non seulement de l'autoionisation de l'iodure mercurique même, mais aussi de la présence d'un certain taux d'autres sels de mercure ionisés accompagnant l'iodure mercurique à titre d'impuretés par exemple d'autres halogénures, nitrate, sulfate, cyanure, etc.

On continue la purification jusqu'au moment où la conductivité de l'espace cathodique n'augmente plus ou très lentement. La solution est alors purifiée des cations d'impuretés, la pureté atteint 6–7N. Une purification supplémentaire peut être effectuée pour éliminer aussi les anions d'impuretés en procédant de la même façon, mais en inversant la polarité. On peut prendre comme produits de départ l'iodure mercurique 5N du commerce ou de l'iode 5N et du mercure 7N du commerce qu'on fait réagir en solution en quantités stœchiométriques. Le processus de purification par électrolyse se simplifie mais reste toujours nécessaire. On filtre la solution sur un entonnoir avec plaque filtrante en quartz fritté pour éliminer les particules de graphite provenant des électrodes.

Une partie de la solution sert comme bain de croissance, une autre partie sert pour récupérer l'iodure mercurique solide. Afin d'obtenir l'iodure mercurique solide, on précipite l'iodure mercurique avec de l'eau ultra-pure de conductivité 0,1 $\mu Scm^{-1}$, on filtre sur entonnoir avec plaque filtrante en quartz fritté, puis on sèche le précipité sous vide à 60 °C. L'iode en excès qui résulte de l'électrolyse s'évapore sous vide. A partir d'un litre de solution on récupère 1700 g d'iodure mercurique 7N. Le rendement total de la purification par électrolyse dépend de la pureté de l'iodure mercurique de départ mais il reste toutefois très élevé, de l'ordre de 80–90%.

Ce bain de croissance utilisé dans l'exemple décrit est une solution purifiée par électrolyse comme décrit ci-dessus, saturée à 25 °C en iodure mercurique alpha dans un mélange de diméthylsulfoxyde et de méthanol, dans laquelle on ajoute en outre un excès d'iode. Pour une fraction molaire de DMSO dans le mélange comprise entre 0,6 et 0,8, le rapport molaire d'iodure mercurique dans la solution est compris entre 0,22 et 0,36. L'iode est ajouté jusqu'à obtenir un rapport molaire $(I_2)/(HgI_2)$ de l'ordre de $10^{-2}$ à $10^{-4}$. On fait croître à partir de cette solution, entre 25 et 40 °C, des monocristaux d'iodure mercurique alpha en utilisant les techniques classiques de croissance en solution: soit par abaissement de la température de la solution, soit par dilution avec du méthanol, soit par recirculation de la solution.

Dans l'exemple, on utilise la technique de recirculation de la solution, qui consiste à utiliser deux récipients qui communiquent entre eux, l'un d'eux contenant les polycristaux à dissoudre et l'autre contenant des germes à faire croître, à maintenir le récipient de dissolution à une température supérieure à celle du récipient de croissance et à faire circuler continuellement la solution d'un récipient à l'autre. Ainsi, en fonction de la différence de température entre les récipients et de la vitesse de la solution, il s'établit un transfert de masse stationnaire qui produit une certaine vitesse de croissance des monocristaux.

La réalisation du procédé s'effectue dans l'appareillage schématiquement représenté sur la fig. 2. Cet appareillage comporte deux récipients 11 et 12 en quartz pour les semi-conducteurs, qui communiquent entre eux. Le récipient de dissolution 11 contient des polycristaux d'iodure mercurique alpha purifié par électrolyse dans un bécher de polytétrafluoréthylène 14 percé de trous.

On prépare une solution saturée d'iodure mercurique alpha purifié par électrolyse, à 25 °C dans le mélange DMSO-MeOH de fraction molaire (DMSO)/(DMSO) + (MeOH) = 0,8, on ajoute un excès d'iode ultra-pur de $10^{-3}$ molaire par rapport à l'iodure mercurique et on remplit les deux récipients avec cette solution. On monte un agitateur en quartz dans le récipient de croissance et on porte la température du thermostat de croissance par exemple à 40 °C et la température du thermostat de dissolution à 35 °C. Après 48 heures, la

solution circulant entre les deux récipients par convection thermique devient saturée en iodure mercurique alpha à 35 °C.

On retire l'agitateur du récipient de croissance et on introduit un arbre agitateur en quartz 13 portant un ou plusieurs porte-germes en polytétrafluoréthylène, conformément au dessin de la fig. 3, contenant des germes mis dans les cavités des plaques porte-germe. Les cavités des plaques sont prismatiques en forme de queue d'aronde. Les germes sont taillés avec une scie à fil humide à partir de gros monocristaux de bonne qualité cristalline. Ils sont de forme prismatique.

Conformément à la fig. 3, qui indique les différents plans, chaque cristal 21 est taillé en forme de prisme droit à section triangulaire isocèle pour présenter, entre les bases d'extrémité constituées par des faces (001), deux faces latérales rectangulaires constituées par des faces (110) et une face latérale rectangulaire constituée par une face (100), de longueur d'au moins 10 mm au long de la direction [001]. Le germe repose sur sa face (100) au fond de la cavité 22. Celle-ci est en forme prismatique de section rectangulaire, sur une largeur correspondant sensiblement à celle de la face (100) du germe. Elle est terminée par deux faces planes inclinées l'une vers l'autre par dessus le germe, donnant ainsi la forme de queue d'aronde.

On porte la température du récipient de cristallisation, par exemple, à 32 °C et on laisse inchangée la température du récipient de dissolution.

Le transport de masse de l'iodure mercurique alpha se fait entre les deux récipients par convection de concentration. L'arbre agitateur 13 tourne à une vitesse de 60 tours-$min^{-1}$ avec un changement de sens de rotation toutes les 30 secondes.

La croissance s'effectue à une vitesse de l'ordre de 0,5 mm par jour, pour atteindre un volume de 36 à 73 $cm^3$ en 2 à 3 mois.

Au bout de deux à trois mois, on obtient ainsi un ou plusieurs monocristaux d'iodure mercurique alpha de 60–70 mm de longueur, de 20–30 mm d'épaisseur et de 30–35 mm de hauteur pesant entre 225 et 475 g, ayant un faciès octaédrique-pinacoïdal. On retire les cristaux du bain de croissance après avoir évacué la solution et laissé le récipient de croissance se refroidir progressivement à la température ambiante.

Les monocristaux d'iodure mercurique alpha ainsi obtenus sont parfaitement transparents, exempts d'inclusions de solution, de fautes d'empilement, de joints de grains, de tensions internes et de déformations. Le taux de dislocations reste de l'ordre de 10 $cm^{-2}$ et la pureté est de l'ordre de 6–7N. La principale impureté résiduelle est le silicium.

Les monocristaux d'iodure mercurique alpha obtenus par le procédé de l'invention sont utilisables pour la fabrication de détecteurs et de spectromètres de radiation X et gamma et ils présentent l'avantage d'augmenter les perfomances de ces détecteurs et de ces spectromètres par rapport aux cristaux obtenus par les procédés antérieurs. Ils présentent notamment pour ces utilisations les caractéristiques suivantes pour le produit mobilité x durée de vie des porteurs de charges:

électrons: $3 \times 10^{-4} \geqslant \mu_e\tau_e \geqslant 5.10^{-5}$ $cm^2/V$,
trous: $5 \times 10^{-6} \geqslant \mu_h\tau_h \geqslant 5.10^{-7}$ $cm^2/V$.

Il est évident cependant, que l'invention n'est pas limitée aux particularités décrites à titre d'exemple.

## Revendications

1. Procédé de fabrication de monocristaux d'iodure mercurique alpha à faciès octaédrique-pinacoïdal par croissance en solution, procédé selon lequel on utilise une solution d'iodure mercurique alpha dans un sulfoxyde organique, caractérisé en ce que l'on provoque la croissance sur un germe reposant par sa face (100) sur le fond d'une cavité prismatique de section rectangulaire ménagée dans un porte-germe selon la direction [001] du germe, ladite cavité étant en forme de queue d'aronde, avec des faces d'extrémités inclinées pour se rapprocher au-dessus du germe.

2. Procédé selon la revendication 1, caractérisé en ce que l'on utilise une solution d'iodure mercurique alpha dans le diméthylsulfoxyde en mélange avec du méthanol de fraction molaire en sulfoxyde organique comprise entre 0,6 et 0,9, en présence d'un excès d'iode.

3. Procédé selon la revendication 2, caractérisé en ce que la solution contient initialement un excès d'iode avec un rapport molaire $(I_2)/(HgI_2)$ compris entre $10^{-4}$ et $10^{-2}$.

4. Procédé selon l'une quelconque des revendications 1 à 3, caractérisé en ce que l'on provoque la croissance sur un germe de forme prismatique limité latéralement par une face (100) et deux faces (110) symétriques.

5. Procédé selon la revendication 4, caractérisé en ce que le germe est terminé aux extrémités par deux faces (001).

6. Procédé selon l'une quelconque des revendications 1 à 5, caractérisé en ce que qu'au cours de l'opération de croissance, la température de la solution est maintenue entre 25 et 40 °C.

7. Procédé selon l'une quelconque des revendications 1 à 6, caractérisé par une vitesse de croissance de l'ordre de 0,5 mm par jour.

8. Procédé selon l'une quelconque des revendications 1 à 7, caractérisé en ce que l'on utilise une solution d'iodure mercurique alpha dans un sulfoxyde organique, de préférence additionné de méthanol, que l'on purifie au préalable par électrolyse pour éliminer les cations et/ou les anions de composés plus ionisés que l'iodure mercurique.

9. Procédé selon la revendication 8, caractérisé en ce que l'on effectue l'électrolyse jusqu'à conductivité constante de moins de 100 $\mu Scm^{-1}$ à 20 °C.

10. Monocristaux d'iodure mercurique alpha à faciès octaédrique-pinacoïdal.

**Claims**

1. Process for the manufacture of monocrystals of alpha mercuric iodide of octahedral pinacoid habit by growth in solution, said process employing a solution of alpha mercuric iodide in an organic sulphoxide, characterized in that crystal growth is produced on a seed crystal whose (100) face rests on the bottom of a prismatic cavity of rectangular cross-section formed in a seed-holder in the direction [001] of the seed crystal, said cavity being of dovetail form with inclined end faces approaching one another above the seed crystal.

2. Process according to claim 1, characterized by the use of a solution of alpha mercuric iodide in a mixture of dimethyl sulphoxide and methanol, the molar fraction of organic sulphoxide being from 0.6 to 0.9, in the presence of an excess of iodine.

3. Process according to claim 2, characterized in that the solution initially contains an excess of iodine with a molar ratio of $(I_2)/(H_gI_2)$ between $10^{-4}$ and $10^{-2}$.

4. Process according to any one of claims 1 to 3, characterized in that crystal growth is produced on a seed crystal of prismatic form delimited by a (100) face and two symmetrical (110) faces.

5. Process according to claim 4, characterized in that the seed crystal has two (001) faces at its ends.

6. Process according to any one of claims 1 to 5, characterized in that the temperature is maintained between 25 and 40 °C during crystal growth.

7. Process according to any one of claims 1 to 6, characterized by a speed of crystal growth of the order of 0.5 mm per day.

8. Process according to any one of claims 1 to 7, characterized by the use of a solution of alpha mercuric iodide in an organic sulphoxide, preferably additionally containing methanol, which has been preliminarily purified by electrolysis to eliminate cations and/or anions of compounds more ionized than mercuric iodide.

9. Process according to claim 8, characterized in that electrolysis is effected until a constant conductivity of at least 100 µ 5 $cm^{-1}$ at 20 °C.

10. Monocrystals of alpha mercuric iodide of octahedral pinacoid habit.

**Patentansprüche**

1. Verfahren zur Herstellung von alpha-Quecksilber(II)-jodid-Einkristallen mit oktaedrisch pinakoidalen Kristallflächen durch Wachstum in Lösung, wobei man bei dem Verfahren eine Lösung von alpha-Quecksilber(II)-jodid in einem organischen Sulfoxid verwendet, dadurch gekennzeichnet, dass man das Wachstum an einem Keim bewirkt, der auf seiner Fläche (100) am Boden eines prismatischen Hohlraums mit rechteckigem Querschnitt liegt, der in einem Keimhalter gemäss der Richtung [001] des Keims ausgebildet ist, wobei dieser Hohlraum in Schwalbenschwanzform, mit den äusseren Enden derart geneigt, dass sie sich über dem Keim nähern, vorliegt.

2. Verfahren nach Anspruch 1, dadurch gekennzeichnet, dass man eine Lösung von alpha-Quecksilber(II)-jodid in dem Dimethylsulfoxid im Gemisch mit Methanol mit einem Molenbruch für das organische Sulfoxid von 0,6 bis 0,9 in Anwesenheit eines Überschusses an Jod verwendet.

3. Verfahren nach Anspruch 2, dadurch gekennzeichnet, dass die Lösung ursprünglich einen Überschuss an Jod mit einem Molverhältnis $(I_2)/(HgI_2)$ von $10^{-4}$ bis $10^{-2}$ enthält.

4. Verfahren gemäss einem der Ansprüche 1 bis 3, dadurch gekennzeichnet, dass man das Wachstum an einem Kern mit prismatischer Form durchführt, der seitlich durch eine Fläche (100) und zwei Flächen (110), die symmetrisch angeordnet sind, begrenzt ist.

5. Verfahren nach Anspruch 4, dadurch gekennzeichnet, dass der Keim an seinen äusseren Enden durch zwei Flächen (001) abgeschlossen wird.

6. Verfahren nach einem der Ansprüche 1 bis 5, dadurch gekennzeichnet, dass man im Verlauf des Wachstumsvorgangs die Temperatur der Lösung bei 25 bis 40 °C hält.

7. Verfahren gemäss einem der Ansprüche 1 bis 6, dadurch gekennzeichnet, dass die Wachstumsgeschwindigkeit in der Grössenordnung von 0,5 mm pro Tag liegt.

8. Verfahren nach einem der Ansprüche 1 bis 7, dadurch gekennzeichnet, dass man eine Lösung von alpha-Quecksilber(II)-jodid in einem organischen Sulfoxid, vorzugsweise versetzt mit Methanol, verwendet, die man vorher durch Elektrolyse reinigt, um die Kationen und/oder die Anionen von Verbindungen, die stärker ionisiert sind als das Quecksilber(II)-jodid, zu entfernen.

9. Verfahren nach Anspruch 8, dadurch gekennzeichnet, dass man die Elektrolyse bis zu einer konstanten Leitfähigkeit von weniger als 100 µ $Scm^{-1}$ bei 20 °C durchführt.

10. Alpha-Quecksilber(II)-jodid-Einkristalle mit o taedrischen pinakoidalen Kristallflächen.

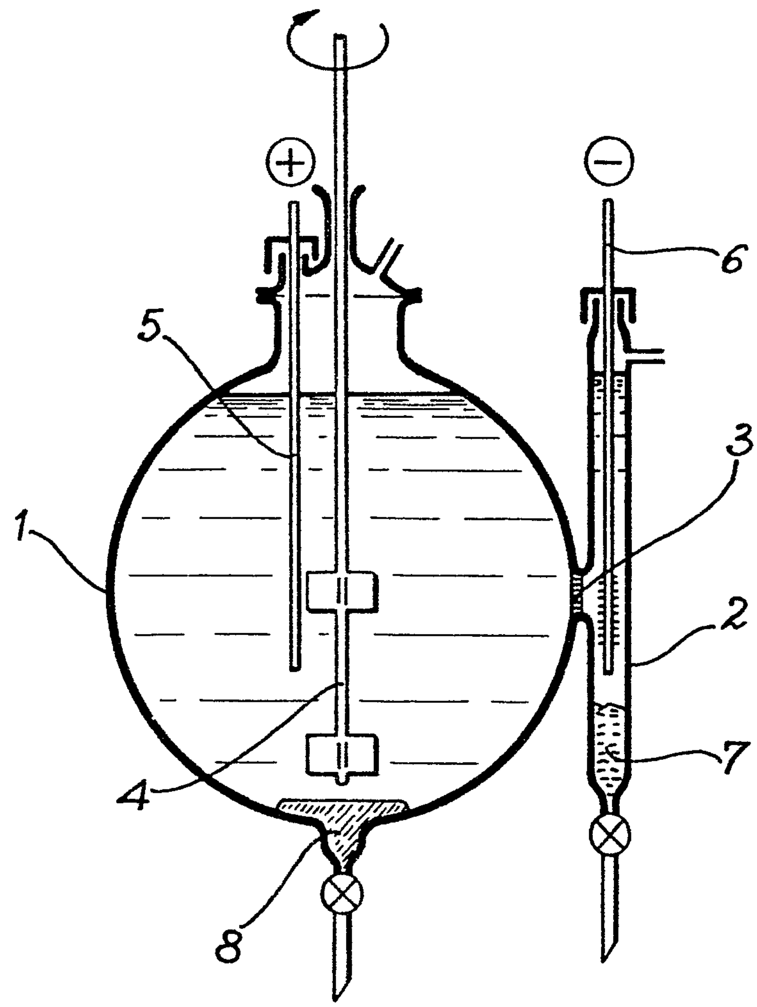


FIG. 1

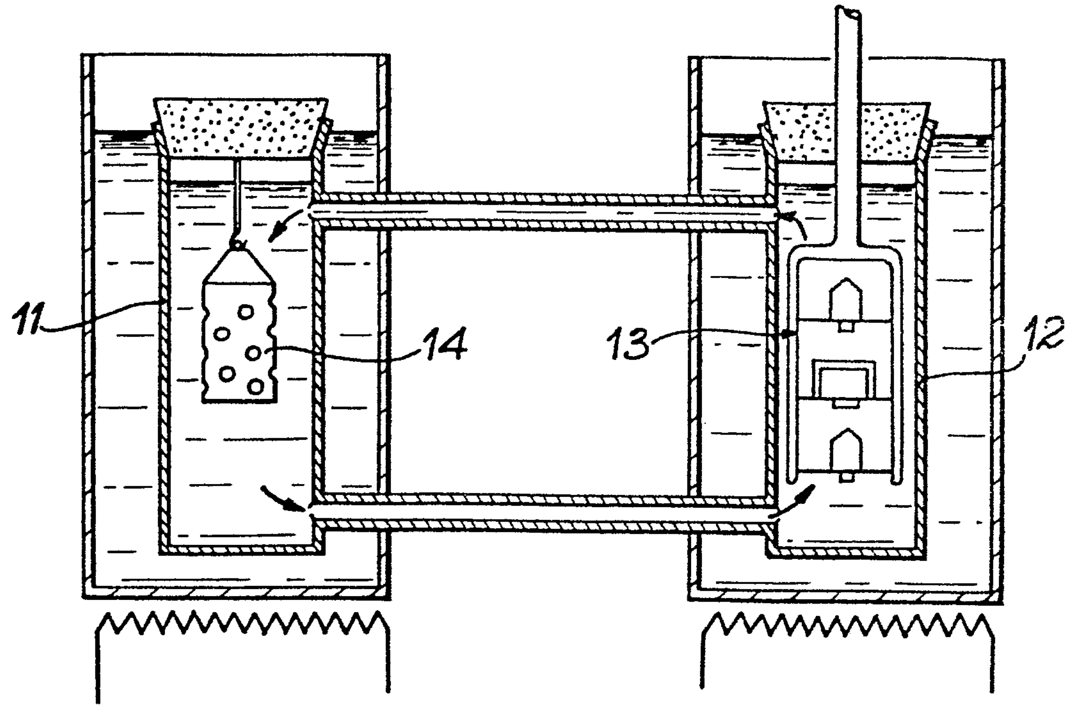


FIG. 2

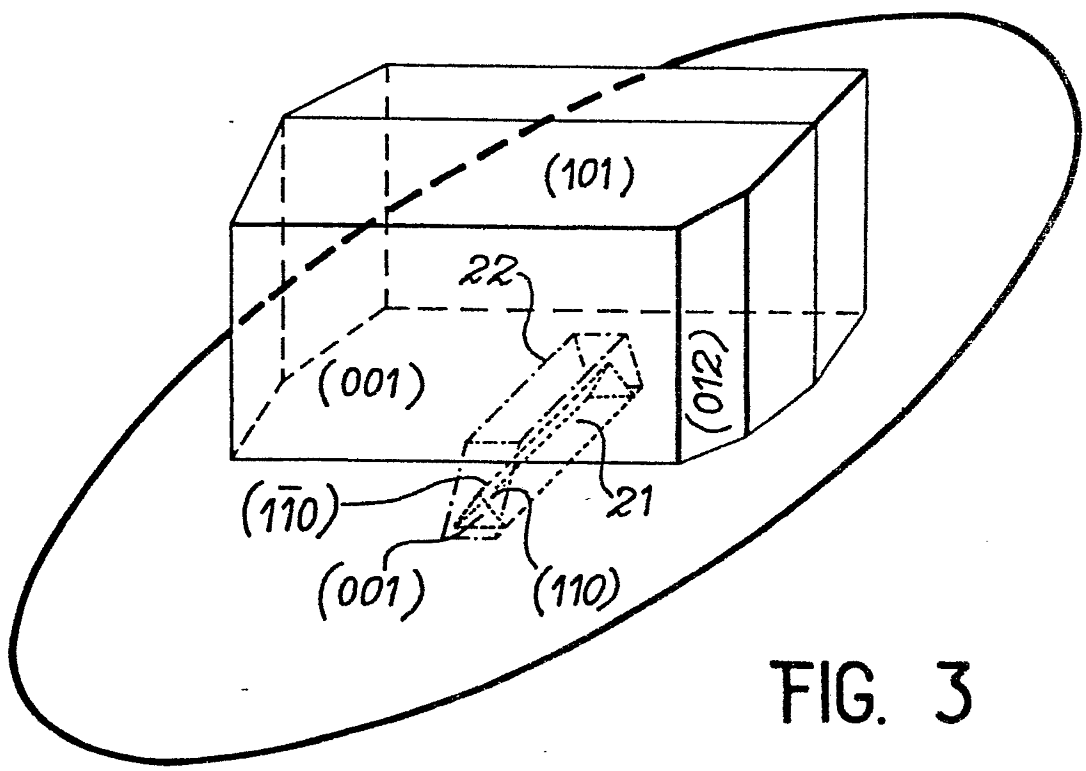


FIG. 3